# EUROPEAN PATENT APPLICATION

(11) **EP 3 579 410 A1**
(43) Date of publication of application: **11.12.2019**
(21) Application number: 18176632.0
(22) Date of filing: 07.06.2018
(51) Int. Cl.: H03F 3/195, H03F 3/21, H03F 3/26, H05H 7/02

(54) **HIGH POWER SOLID STATE RF AMPLIFIER**

(71) Applicant: Ion Beam Applications, 1348 Louvain-la-Neuve (BE)
(72) Inventor: ABS, Michel, 1348 Louvain-la-Neuve (BE); DELVAUX, Jean-Luc, 1348 Louvain-la-Neuve (BE)
(74) Representative: ABYOO

(57) **Abstract**

A solid-state RF power amplifier (1) has an amplifier input (10) and an amplifier output (20). It comprises N solid-state push-pull amplifiers (PP₁, PP₂, ..., PP_{N}), an N-way power splitter (30) connected to the inputs of said N push-pull amplifiers, and an N-way power combiner connected to the outputs of said N push-pull amplifiers. Each push-pull amplifier has a nominal power comprised between 100 W and 10000 W and has a nominal operating frequency comprised between 1 MHz and 1 GHz. The N-way power combiner comprises N output coupling transformer circuits (CTO₁, CTO₂, ..., CTO_{N}) respectively connected and therefore associated to the outputs of the N solid-state push-pull amplifiers. Said output coupling transformer circuits comprise output coupling transformers and the primaries and/or secondaries of said output coupling transformers are connected in series to provide an RF power amplifier output (20) at the extremities of said series connection. Such a configuration provides a cheaper and less cumbersome RF power amplifier.

## Description

### Field of the invention

The invention relates to a high power RF amplifier, more specifically to a high power solid state RF amplifier.
By a high power, one understands a power larger than 1KW.
By RF or Radio-Frequency, one understands in the context of the present invention a frequency comprised between 1 MHz and 1 GHz, preferably between 10 MHz and 100 Mhz. By a solid state amplifier, one understands an amplifier making use of solid state devices (SSD) such as power semiconductors instead of electronic vacuum tubes (triodes, tetrodes, ...) for signal amplification purposes.
The invention also relates to a particle accelerator comprising a high power solid state RF power amplifier.

### Description of prior art

RF power amplifiers nowadays make more and more use of solid state devices (SSD) such as power semiconductors instead of electronic vacuum tubes for amplifying RF signals to high powers. Known SSDs are however not capable of delivering power levels of tens or even hundreds of kilowatts, which are for example required to generate accelerating electric fields in particle accelerators. It is therefore known to combine outputs of multiple solid state devices and/or of multiple solid state amplifiers to achieve the desired high power output.
In conventional designs, RF power combiners make use of transmission lines such as lambda/4 lines. Example combiners of this type are Wilkinson combiners (E.J. Wilkinson, "An N-way Power Divider", IRE Trans. on Microwave Theory and Techniques, vol. 8, p. 116-118, Jan. 1960, doi: 10.1109/TMTT.1960.112466). Though such power combiners work well and have been used for many years, they present several disadvantages: they dissipate quite some waste heat and therefore generally need to be cooled, they have a limited bandwidth, and they require quite some space.

### Summary of the invention

It is an object of the invention to address the problems of the state of the art high power solid state RF amplifiers. It is more specifically an object of the invention to provide a high power solid state RF power amplifier which has a larger bandwidth and/or a lower cost and/or which occupies less space than conventional amplifiers of this kind.

The invention is defined by the independent claims. The dependent claims define advantageous embodiments.

According to the invention, there is provided a solid state RF power amplifier having an amplifier input and an amplifier output and comprising a plurality of N solid-state push-pull amplifiers, an N-way power splitter operationally connected between the amplifier input and the N inputs of the N solid-state push-pull amplifiers, and an N-way power combiner operationally connected between the N outputs of the N solid-state push-pull amplifiers and the amplifier output. The N-way power combiner comprises N output coupling transformer circuits respectively connected and therefore associated to the outputs of the N solid-state push-pull amplifiers. Said output coupling transformer circuits comprise output coupling transformers, and the primaries and/or secondaries of said output coupling transformers are connected in series to provide the amplifier output at the extremities of said series connection.
By RF or Radio-Frequency, one understands in the context of the present invention a frequency comprised between 1 MHz and 1 GHz, preferably between 10 MHz and 100 Mhz. By a solid state amplifier, one understands an amplifier making use of solid state devices (SSD) such as power semiconductors instead of electronic vacuum tubes (triodes, tetrodes, ...) for signal amplification purposes.

Apart from the internal resistances of the output coupling transformers, the power combiner of an RF amplifier according to the invention does not comprise high power resistances and therefore dissipates less waste heat than conventional amplifiers using coupled transmission lines for power combination. Calculations and experimental verifications have shown that specific cooling of the power combiner becomes unnecessary, thereby also saving cost, weight and space. An amplifier according to the invention has generally also a larger bandwidth compared to amplifiers using coupled transmission lines for power combination.

Preferably, each output coupling transformer circuit comprises an output coupling transformer and the output of each push-pull amplifier is respectively connected to the primary of its associated output coupling transformer, whereas the secondaries of the output coupling transformers are connected in series to provide the amplifier output at the two extremities of said series connected secondaries. Such a configuration is for example suited to operate at nominal frequencies up to 100 Mhz.

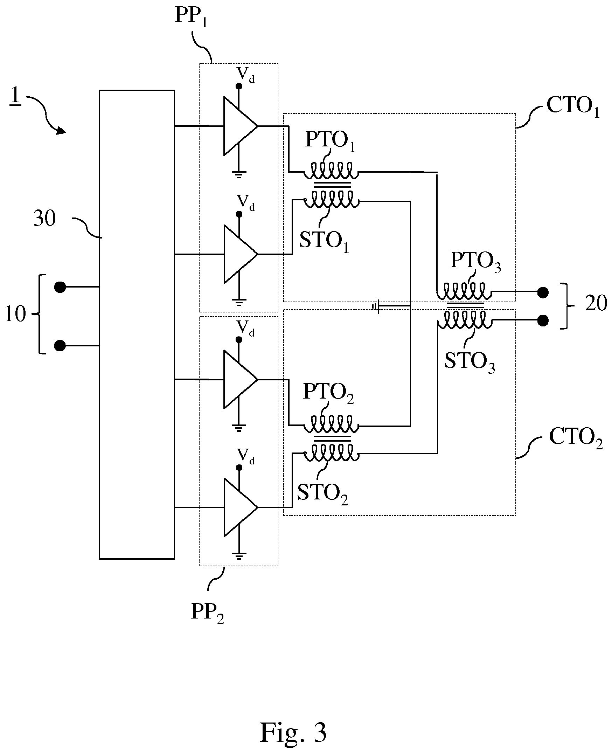

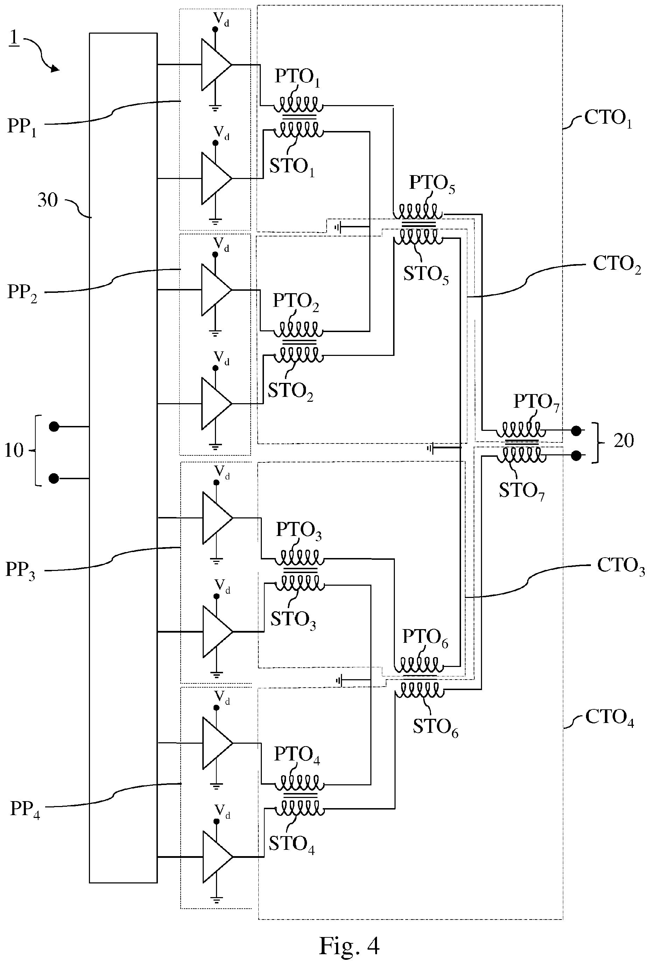

Alternatively, the number N of push-pull amplifiers is preferably an integer power of two (such as N = 2, 4, 8, 16, 32, ....) and the output coupling transformer circuits preferably comprise (2N-1) output coupling transformers which are connected together and to the push-pull amplifiers in a pyramidal fashion as shown on Fig. 3 when N=2, or as shown on Fig.4 when N=4, or in an analogue way when N is larger than 4. Such a configuration is suited to operate at higher frequencies such as for example nominal frequencies up to 1 Ghz.

Preferably, each push-pull amplifier has a nominal output power comprised between 100 W and 10000 W, more preferably between 1000 W and 5000 W, even more preferably between 1300 W and 2000 W.

Preferably, each push-pull amplifier has a nominal operating frequency comprised between 1 MHz and 1 GHz, preferably between 10 MHz and 100 Mhz.

According to the invention, there is also provided a particle accelerator comprising accelerating electrodes for accelerating charged particles and a solid state RF power amplifier according to the invention, the amplifier output of said solid state RF power amplifier being coupled to said accelerating electrodes. Preferably, said particle accelerator is a cyclotron or a synchrotron or a rhodotron or a linear accelerator (sometimes called a linac).

### Short description of the drawings

These and further aspects of the invention will be explained in greater detail by way of examples and with reference to the accompanying drawings in which:
Fig.1 schematically shows an amplifier according to the invention;
Fig.2 shows an amplifier according to a first embodiment of the invention;
Fig.3 shows an amplifier according to a first example of a second embodiment of the invention;
Fig.4 shows an amplifier according to a second example of a second embodiment of the invention;
Fig.5 shows an amplifier according to a preferred first embodiment of the invention;
Fig.6 shows an exemplary physical implementation of an output coupling transformer;
Fig.7 shows an exemplary physical implementation of a plurality of output coupling transformers;
Fig.8 schematically shows a particle accelerator comprising an RF power amplifier according to the invention.

The drawings of the figures are neither drawn to scale nor proportioned. Generally, similar or identical components are denoted by the same reference numerals in the figures.

### Detailed description of embodiments of the invention

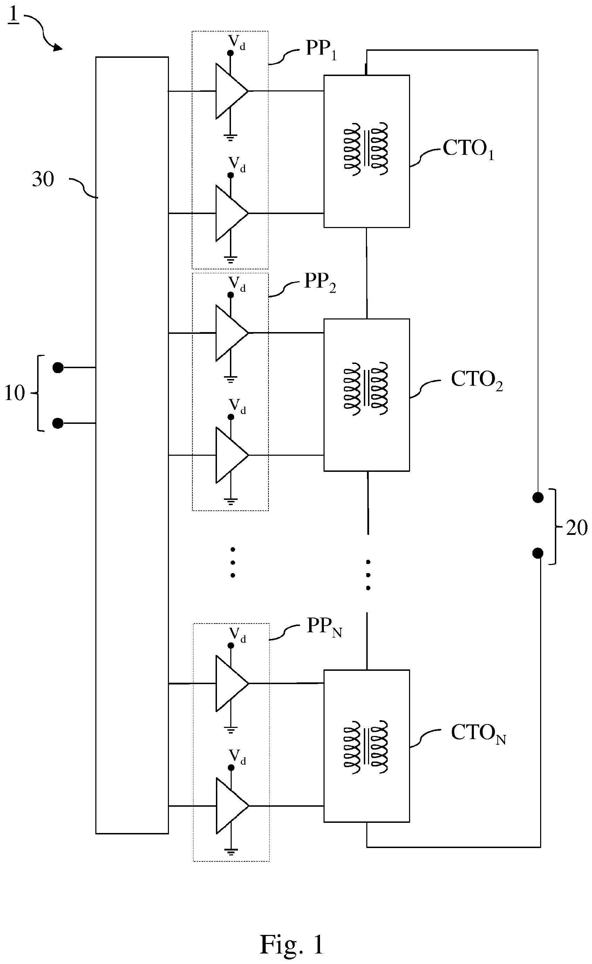

Fig.1 schematically shows a solid state RF power amplifier (1) according to the invention. It has an amplifier input (10) to which an RF signal can be fed, and an amplifier output (20) at which an amplified RF signal is delivered when the RF amplifier is in operation.

For the purpose of RF signal amplification, it comprises a plurality of N solid-state push-pull amplifiers (PP₁, PP₂, ..., PP_{N}) which are preferably all of the same type.
It further comprises an N-way power splitter (30) whose input is connected to or is the amplifier input (10) and whose N outputs are respectively connected to the N inputs of the N solid-state push-pull amplifiers.
It also comprises an N-way power combiner whose N inputs are respectively connected to the N outputs of the N solid-state push-pull amplifiers and whose output is connected to or is the amplifier output (20).
Specific to the invention is that the N-way power combiner comprises N output coupling transformer circuits (CTO₁, CTO₂, ..., CTO_{N}) which are respectively connected and therefore associated to the outputs of the N solid-state push-pull amplifiers (PP₁, PP₂, ..., PP_{N}). Said output coupling transformer circuits comprise output coupling transformers, and the primaries and/or secondaries of said output coupling transformers are connected in series to provide the amplifier output at the extremities of said series connection.

There are several ways to more specifically connect the output coupling transformers to the push-pull amplifiers and to the amplifier output, as will be disclosed in more details in the following two exemplary embodiments.

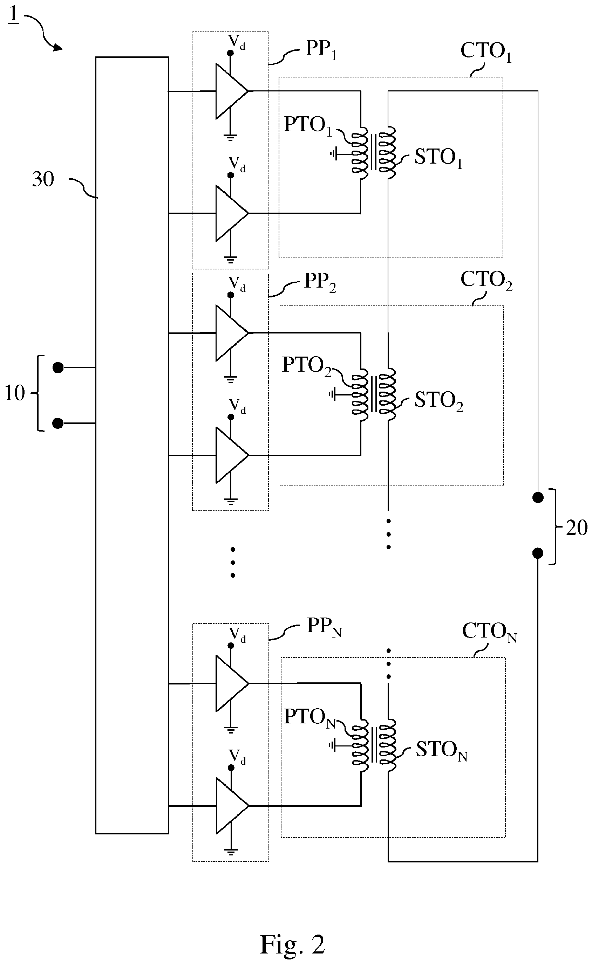

Fig.2 shows a solid state RF power amplifier (1) according to a first exemplary embodiment of the invention.

In this example, each output coupling transformer circuit (CTO₁, CTO₂, ..., CTO_{N}) comprises an output coupling transformer. The output of each push-pull amplifier (PP₁, PP₂, ..., PP_{N}) is respectively connected to the primary (PTO₁, PTO₂, ..., PTO_{N}) of its associated output coupling transformer, whereas the secondaries (STO₁, STO₂, ..., STO_{N}) of the said N output coupling transformers are connected in series to provide the amplifier output (20) at the extremities of said series connected secondaries. In this example, each of the primaries (PTO₁, PTO₂, ..., PTO_{N}) of the output coupling transformers is center-tapped and each center-tap is connected to the mass.

Fig.3 shows a solid state RF power amplifier (1) according to a first example of a second embodiment of the invention. In this example there are two push-pull amplifiers (PP₁, PP₂), two output coupling transformer circuits (CTO₁, CTO₂) and three output coupling transformers, which are interconnected and connected to the push-pull amplifiers in a pyramidal fashion, as shown on Fig.3. More precisely:
- the output of a first push-pull amplifier (PP₁) is connected to one side of the primary (PTO₁) and to one side of the secondary (STO₁) of a first output coupling transformer,
- the output of a second push-pull amplifier (PP₂) is connected to one side of the primary (PTO₂) and to one side of the secondary (STO₂) of a second output coupling transformer,
- the other side of the secondary (STO₁) of the first coupling transformer is connected to the other side of the primary (PTO₂) of the second coupling transformer and to the mass,
- the other side of the primary (PTO₁) of the first coupling transformer is connected to one side of the primary (PTO₃) of a third coupling transformer,
- the other side of the secondary (STO₂) of the second coupling transformer is connected to one side of the secondary (STO₃) of the third coupling transformer, and
- the other side of the primary (PTO₃) and of the secondary (STO₃) of the third coupling transformer form the amplifier output (20).

Fig.4 shows a solid state RF power amplifier (1) according to a second example of a second embodiment of the invention.
In this example, there are four push-pull amplifiers (PP₁, PP₂, PP₃, PP₄), four output coupling transformer circuits (CTO₁, CTO₂, CTO₃, CTO₄) and seven output coupling transformers, which interconnected and connected to the push-pull amplifiers in a pyramidal fashion, as shown on Fig.4.

As will be clear for a skilled person, such a pyramidal interconnection of output coupling transformers may be used in an analogue way when N is an integer power of two which is larger than two (thus for N= 8, 16, 32, ....).

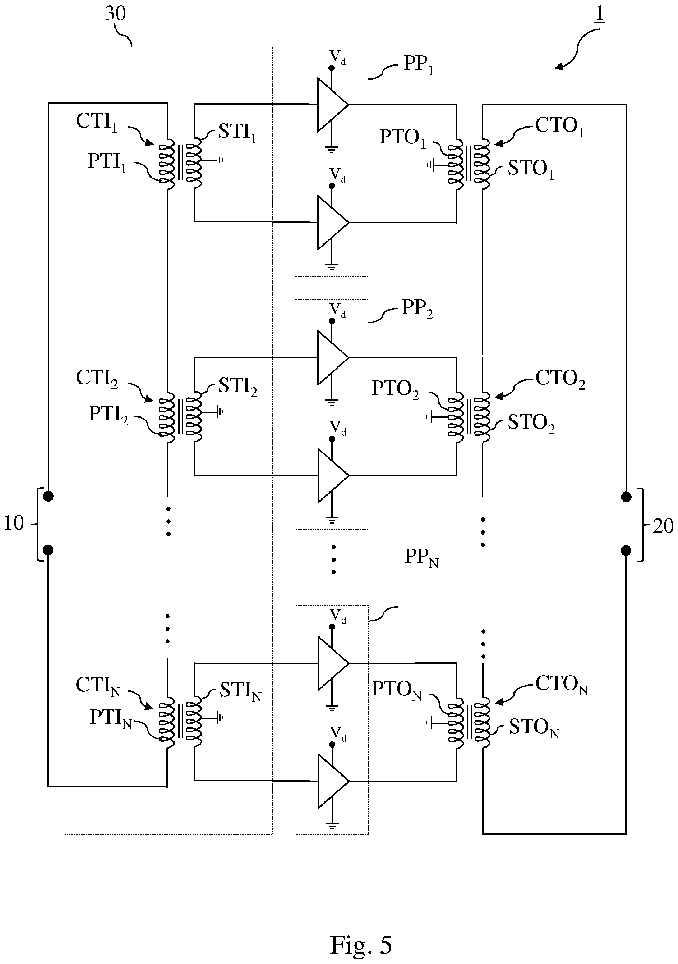

Fig.5 shows a solid state RF power amplifier (1) according to a preferred first embodiment of the invention. It is the same as the solid state RF power amplifier (1) of Fig. 2 but with more details concerning the N-way power splitter (30).
In this example, the N-way power splitter (30) comprises N input coupling transformers (CTI₁, CTI₂, ..., CTI_{N}) , the secondaries (STI₁, STI₂, ..., STI_{N}) of which are connected respectively to the N inputs of the N push-pull amplifiers, and the primaries (PTI₁, PTI₂, ..., PTI_{N}) of which are connected in series, the two extremities of said series connection being the amplifier input (10), as shown on Fig.5.
Obviously, the same N-way power splitter (30) as the one of Fig.5 may be used for the exemplary second embodiments of the invention as shown in Fig.3 and
Fig.4, or for any other configuration according to Fig.1.

Preferably, each push-pull amplifier (PP₁, PP₂, ..., PP_{N}) has a nominal output power comprised between 100 W and 10000 W, preferably between 1000 W and 5000 W, more preferably between 1300 W and 2000 W.
Preferably, each push-pull amplifier (PP₁, PP₂, ..., PP_{N}) has a nominal operating frequency comprised between 1 MHz and 1 GHz, preferably between 10 MHz and 100 Mhz.
To build a push-pull amplifier one may for example use two RF power transistors such as NXP Semiconductor's MRF1K50H LDMOS transistors for example, which can operate from 1.8 MHz to 500 MHz and deliver 1500W CW power.

Preferably, 1<N<10. More preferably 1<N<6. Even more preferably N= 4.
The inventors have found that these preferred values of N provide for acceptable parasitic capacitance values between primaries and secondaries of the coupling transformers and for optimum space occupancy in the operating RF frequency range, especially when the RF amplifier is to be rack-mounted in standard IEC racks for example.

Preferably, each output coupling transformer has a turns ratio of 1/1.
This is advantageous because, since most SSD power transistors have a low output impedance of around 5 ohms, and since broadband transformers convert impedances by the square of their turns ratio, one will find the same low impedance at the output of the secondary of each output coupling transformer. Hence, when these secondaries are connected in series, as is at least the case with the first embodiment, one may for example obtain a desired output impedance of 25 ohms or of 50 ohms.

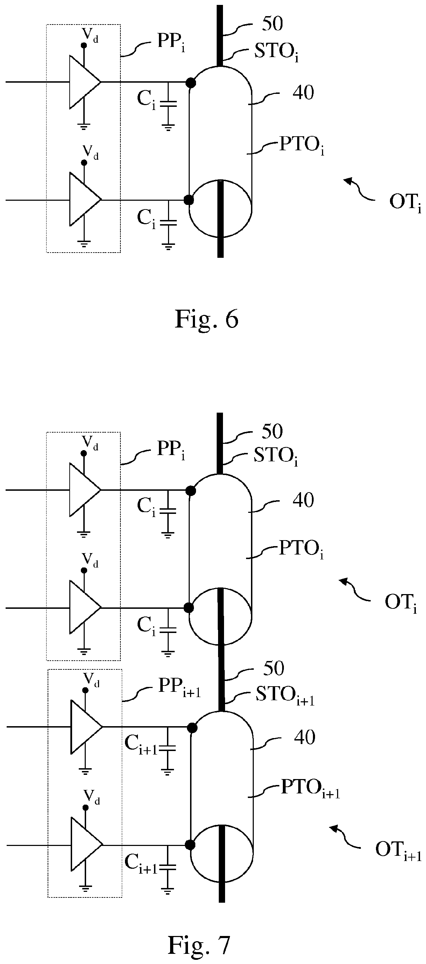

Fig.6 shows an exemplary physical implementation of an output coupling transformer in case of the first embodiment. In this example, each output coupling transformer (OTi) comprises:
- an outer conductor (40) (40) having the shape of a hollow cylinder whose axial extremities are the terminals of the primary (PTOi) of said output coupling transformer, and
- an inner conductor (50) (50), arranged coaxially inside the outer conductor (40) (40), and whose axial extremities are the terminals of the secondary (STOi) of said output coupling transformer.

Fig.7 shows an exemplary physical implementation of a plurality of output coupling transformers in case of the first embodiment. In this example, the inner conductor (50)s (50) of two output coupling transformers (OTᵢ, OTᵢ₊₁) are connected together and arranged coaxially. For the sake of clarity, only two output coupling transformers are shown in this example but it will be obvious that further output coupling transformers can also be connected and arranged coaxially in the same manner.
Preferably, the inner conductor (50)s (50) of at least two output coupling transformers are together formed of a single continuous piece of metal.

Preferably, none of the said output coupling transformers comprises a ferrite part. Particularly, none of the said output coupling transformers comprises a ferrite part - such as a ferrite ring for example - around their outer conductor (40)s (40). Instead, in the case of the first embodiment, filter capacitors (Ci, Ci+1) are connected between each terminal of the primary (PTOi, PTOi+1) of each output coupling (OTi, OTi+1) transformer and the mass, respectively, as shown on Figs. 6 and 7 for example. Each of these filter capacitors has for example a capacitance comprised between 500 pF and 5nF, for example 1nF. In the case of the first embodiment, an additional filter capacitor (not shown) may be connected between one extremity of the series connection the secondaries (STO₁, STO₂, ..., STO_{N}) of the output coupling transformers, and the mass. This additional filter capacitor has for example a capacitance comprised between 10 pF and 1nF, for example 50pF.

According to the invention, there is also provided a charged particle accelerator comprising accelerating electrodes for accelerating the charged particles and a solid state RF power amplifier (1) according to the invention, the amplifier output of said solid state RF power amplifier (1) being coupled to said accelerating electrodes.
Preferably, said particle accelerator is a cyclotron or a synchrotron or a rhodotron or a linear accelerator (sometimes called a Linac).

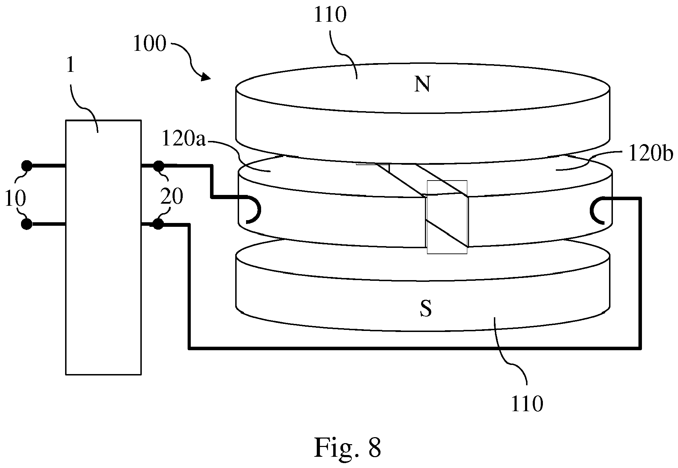

Fig.8 schematically shows an exemplary cyclotron comprising a main magnet (110) and two accelerating electrodes (120a, 120b) (sometimes called "dees"). The amplifier output (20) of a solid state RF power amplifier (1) (1) according to the invention is coupled to the accelerating electrodes (120a, 120b) to generate an RF electric field for charged particle acceleration.

Said particle accelerator may for example be adapted to output a charged particle beam at an energy comprised between 1 MeV and 100 MeV, preferably between 5 MeV and 80 MeV, more preferably between 8 MeV and 70 MeV. Such particle accelerators are for example used in radiopharma applications to produce isotopes.

Said particle accelerator may for example alternatively be adapted to output a particle beam at an energy comprised between 50 MeV and 500 MeV, preferably between 100 MeV and 300 MeV, more preferably between 200 MeV and 250 MeV. Such particle accelerators are for example used in particle therapy applications, such as in proton therapy installations for example.

The present invention has been described in terms of specific embodiments, which are illustrative of the invention and not to be construed as limiting. More generally, it will be appreciated by persons skilled in the art that the present invention is not limited by what has been particularly shown and/or described hereinabove.
Reference numerals in the claims do not limit their protective scope.
Use of the verbs "to comprise", "to include", "to be composed of", or any other variant, as well as their respective conjugations, does not exclude the presence of elements other than those stated.
Use of the article "a", "an" or "the" preceding an element does not exclude the presence of a plurality of such elements.
The invention may also be described as follows: a solid-state RF power amplifier (1) having an amplifier input (10) and an amplifier output (20) and comprising N solid-state push-pull amplifiers (PP₁, PP₂, ..., PP_{N}), an N-way power splitter (30) connected to the inputs of said N push-pull amplifiers, and an N-way power combiner connected to the outputs of said N push-pull amplifiers. Each push-pull amplifier has a nominal power comprised between 100 W and 10000 W and has a nominal operating frequency comprised between 1 MHz and 1 GHz. The N-way power combiner comprises N output coupling transformer circuits (CTO₁, CTO₂, ..., CTO_{N}) respectively connected and therefore associated to the outputs of the N solid-state push-pull amplifiers. Said output coupling transformer circuits comprise output coupling transformers and the primaries and/or secondaries of said output coupling transformers are connected in series to provide an RF power amplifier output (20) at the extremities of said series connection.

## Claims

1. Solid state RF power amplifier (1) having an amplifier input (10) and an amplifier output (20) and comprising a plurality of N solid-state push-pull amplifiers (PP₁, PP₂, ..., PP_{N}), an N-way power splitter (30) operationally connected between the amplifier input (10) and the N inputs of the N solid-state push-pull amplifiers, and an N-way power combiner operationally connected between the N outputs of the N solid-state push-pull amplifiers and the amplifier output (20),
**characterized in that** the N-way power combiner comprises N output coupling transformer circuits (CTO₁, CTO₂, ..., CTO_{N}) respectively connected and therefore associated to the outputs of the N solid-state push-pull amplifiers (PP₁, PP₂, ..., PP_{N}), **in that** said output coupling transformer circuits comprise output coupling transformers, and **in that** primaries and/or secondaries of said output coupling transformers are connected in series to provide the amplifier output at the extremities of said series connection.

2. Solid state RF power amplifier according to claim 1, **characterized in that** each output coupling transformer circuit (CTO₁, CTO₂, ..., CTO_{N}) comprises an output coupling transformer, **in that** the output of each push-pull amplifier (PP₁, PP₂, ..., PP_{N}) is respectively connected to the primary (PTO₁, PTO₂, ..., PTO_{N}) of its associated output coupling transformer and **in that** the secondaries (STO₁, STO₂, ..., STO_{N}) of the output coupling transformers are connected in series to provide the amplifier output (20) at the extremities of said series connected secondaries.

3. Solid state RF power amplifier according to claim 1, **characterized in that** the number N of push-pull amplifiers is an integer power of two, and **in that** the output coupling transformer circuits (CTO1, CTO2, ..., CTON) comprise (2N-1) output coupling transformers which are connected together and to the push-pull amplifiers in a pyramidal fashion as shown on Fig. 3 when N=2, or as shown on Fig.4 when N=4, or in an analogue way when N is larger than 4.

4. Solid state RF power amplifier according to any of preceding claims, **characterized in that** each push-pull amplifier (PP₁, PP₂, ..., PP_{N}) has a nominal output power comprised between 100 W and 10000 W, preferably between 1000 W and 5000 W, more preferably between 1300 W and 2000 W.

5. Solid state RF power amplifier according to any of preceding claims, **characterized in that** each push-pull amplifier (PP₁, PP₂, ..., PP_{N}) has a nominal operating frequency comprised between 1 MHz and 1 GHz, preferably between 10 MHz and 100 Mhz,

6. Solid state RF power amplifier according to any of preceding claims, **characterized in that** 1<N<10, preferably 1<N<6, more preferably N= 4.

7. Solid state RF power amplifier according to any of preceding claims, **characterized in that** each output coupling transformer has a turns ratio of 1/1.

8. Solid state RF power amplifier according to any of preceding claims, **characterized in that** each output coupling transformer comprises:
- an outer conductor (40) having the shape of a hollow cylinder and whose axial extremities are the terminals of the primary of said output coupling transformer, and
- an inner conductor (50), arranged coaxially inside the outer conductor (40) and whose axial extremities are the terminals of the secondary of said output coupling transformer.

9. Solid state RF power amplifier according to claim 8, **characterized in that** the inner conductors (50) of at least two output coupling transformers are arranged coaxially.

10. Solid state RF power amplifier according to any of previous claims, **characterized in that** none of the said output coupling transformers comprises a ferrite part.

11. Particle accelerator (100) comprising accelerating electrodes (120a, 120b) for accelerating charged particles and a solid state RF power amplifier (1) according to any of previous claims, on amplifier output of said solid state RF power amplifier (1) being coupled to said accelerating electrodes (120a, 120b).

12. Particle accelerator according to claim 11, **characterized in that** said particle accelerator is a cyclotron or a synchrotron or a rhodotron or a linac.

13. Particle accelerator according to claim 11 or 12, **characterized in that** said particle accelerator is adapted to output a charged particle beam at an energy comprised between 1MeV and 100 MeV, preferably between 5 MeV and 80 MeV, more preferably between 8 MeV and 70 MeV.

14. Particle accelerator according to claim 11 or 12, **characterized in that** said particle accelerator is adapted to output a charged particle beam at an energy comprised between 50 MeV and 500 MeV, preferably between 100 MeV and 300 MeV, more preferably between 200 MeV and 250 MeV.
